# EUROPÄISCHE PATENTSCHRIFT

(11) **EP 0 765 016 B1**
(45) Veröffentlichungstag und Bekanntmachung des Hinweises auf die Patenterteilung: **05.12.2001**
(21) Anmeldenummer: 96114648.7
(22) Anmeldetag: 12.09.1996
(51) Int. Cl.: H01S 5/06, H01S 5/042

(54) **Wellenlängenabstimmbare Laservorrichtung**
Wavelength tunable laser device
Dispositif laser à longueur d'onde accordable

(30) Priorität: 20.09.1995 DE 19534937
(43) Veröffentlichungstag der Anmeldung: 26.03.1997
(73) Patentinhaber: Infineon Technologies AG, 81669 München (DE)
(72) Erfinder: Stein, Karl-Ulrich, Dr., 82008 Unterhaching (DE)
(74) Vertreter: Zedlitz, Peter, Dipl.-Inf.

(56) Entgegenhaltungen:
- EP-A- 0 333 494
- EP-A- 0 354 776
- EP-A- 0 635 917
- US-A- 4 669 086
- ELECTRONICS LETTERS, Bd. 28, Nr. 16, 30.Juli 1992, Seiten 1499-1500, XP000309693 LOURTIOZ J M ET AL: "Fourier-transform-limited pulses from gain-switched distributed-Bragg-reflector lasers using simultaneous modulation of gain and phase-sections"
- JOURNAL OF LIGHTWAVE TECHNOLOGY, Bd. 11, Nr. 7, 1.Juli 1993, Seiten 1168-1182, XP000402587 AMANN M -C ET AL: "Tunable laser diodes utilizing transverse tuning scheme"

## Beschreibung

Die Erfindung bezieht sich auf eine wellenlängenabstimmbare Laservorrichtung mit einem einen aktiven Laserbereich aufweisenden Aktivteil zur Erzeugung eines Laserlichtes mit einer vorbestimmter Emissionswellenlänge und einem einen dem aktiven Laserbereich zugeordneten Abstimmbereich aufweisenden und die Emissionswellenlänge des vom aktiven Bereich ausgesandten Laserlichtes abstimmbaren Abgleichteil, wobei der Aktivteil mit einem zeitlich variablen Modulationsstrom beaufschlagt ist, der die Intensität des ausgesandten Laserlichtes steuert, und der Abgleichteil mit einem elektrischen Abgleichstrom zur Steuerung der Emissionswellenlänge des ausgesandten Laserlichtes beaufschlagt ist.

Eine derartige Laservorrichtung ist beispielsweise aus Aufsätzen von M.-C. Amann, unter anderem in Electronics Letters, Vol. 26, No. 1, 4. Januar 1990, Seiten 46 und 47 (Over 7 nm (875 Ghz) continuous Wavelength tuning by tunable twin-guide (TTG) laser diode), und in Electronics Letters, Vol. 26, No. 22, 25. Oktober 1990, Seiten 1845 und 1846 (continuously tunable metal-clad ridge-waveguide distributed feedback laser diode) als Bestandteil von Übertragungssystemen mit Lichtwellenleitern bekannt. Nachteilig bei diesen Übertragungssystemen ist die Begrenzung der Reichweite des übertragenen Signals aufgrund von Dispersion in der Faser und aufgrund des Laserchirps, insbesondere im Bereich der übertragenen Wellenlängen um 1,55 µm, in dem die Faserverstärker wirken. Eine der Ursachen der nichterwünschten Reichweitenbegrenzung liegt in dem sogenannten adiabatischen Chirp des verwendeten Lasers aufgrund der Abhängigkeit der Wellenlänge der vom Laser ausgesandten Strahlung von dem am Laser angelegten Modulationsstrom zur Steuerung der Intensität des ausgesandten Laserlichts. Bisher wurde versucht, die aufgrund des Chirpverhaltens des Lasers auftretende unerwünschte Reichweitenbegrenzung zum einen über spezielle dispersionskompensierende Fasern, die an bestimmten Stellen in der Übertragungsstrecke angebracht wurden, und zum anderen durch den Einsatz speziell ausgesuchter Laser, die unter Modulation eine geringe spektrale Bandbreite aufweisen, zu kompensieren bzw. zu minimieren. Beide bisher eingesetzten Maßnahmen zur Kompensation der Auswirkungen auf die Reichweite einer unerwünschten Frequenzmodulation aufgrund von Chirp sind aufwendig und entsprechend kostenungünstig. In den meisten Anwendungsfällen wurden daher keine besonderen Maßnahmen zur Beseitigung dieser Nachteile vorgenommen, sondern eine Begrenzung der Übertragungsreichweite in Kauf genommen.

Der Erfindung liegt die Aufgabe zugrunde, eine wellenlängenabstimmbare Laservorrichtung als Sender für ein optoelektronisches Übertragungssystem zur Verfügung zu stellen, welche mit schaltungstechnisch geringstem Aufwand eine wenigstens annähernd chirp-freie Übertragung optoelektronischer Datensignale über Lichtwellenleiter ermöglicht.

Diese Aufgabe wird durch eine wellenlängenabstimmbare Laservorrichtung nach Anspruch 1 gelöst.

Erfindungsgemäß ist vorgesehen, daß der dem Abgleichteil zugeführte und die Emissionswellenlänge des ausgesandten Laserlichts steuernde Abgleichstrom unmittelbar aus dem zeitlich variablen Modulationsstrom abgeleitet ist. Hierbei ist dem Prinzip der Erfindung folgend vorgesehen, daß der aus dem zeitlich variablen Modulationsstrom unmittelbar abgeleitete Abgleichstrom den auf den aktiven Laserbereich wirkenden Abstimmbereich so steuert, daß die Emissionswellenlänge des ausgesandten Laserlichts unabhängig von der Intensität des Modulationsstromes und im wesentlichen wenigstens annähernd auf einem konstanten Wert gehalten wird.

Die Abstimmfähigkeit wird gemäß Erfindung verwendet, um die unerwünschte Frequenzmodulation aufgrund von Chirp zu kompensieren. Der adiabatische Chirp eines Lasers ist proportional zum angelegten Modulationsstrom, d.h. die Frequenzablage des Lasers durch Modulation des aktiven Laserbereichs ist proportional zum angelegten Stromsignal, so daß der Laser chirpt. Ebenfalls proportional zum angelegten Strom am Abstimmbereich ist die Frequenzablage des Lasers. Werden beide Laserbereiche mit einem dem angelegten Modulationsstrom entsprechenden Signal unter Beachtung der entsprechenden Proportionalitätskonstanten angesteuert, so kompensieren sich die Chirpanteile der beiden Laserbereiche.

Erfindungsgemäß ist vorgesehen, daß eine Differenzverstärkerschaltung mit zwei untereinander gekoppelten Schaltungszweigen vorgesehen ist, wobei der eine Schaltungszweig der Differenzverstärkerschaltung dem Aktivteil zugeordnet ist und den zeitlich variablen Modulationsstrom für die direkte Modulation des aktiven Laserbereiches führt, und der zweite Schaltungszweig der Differenzverstärkerschaltung dem Abgleichteil zugeordnet ist und den unmittelbar aus dem Modulationsstrom abgeleiteten Abgleichstrom liefert. Bei einer schaltungsmäßig besonders einfachen Ausführung der Erfindung kann vorgesehen sein, daß die Differenzverstärkerschaltung einen dem ersten Schaltungszweig zugeordneten ersten Transistor und einen dem zweiten Schaltungszweig zugeordneten zweiten Transistor aufweist, wobei an dem Steuer- bzw. Basisanschluß des ersten Transistors ein dem zeitlich variablen Modulationsstrom entsprechendes Steuersignal anliegt, und der eine Elektroden- bzw. Emitteranschluß des zweiten Transistors mit dem einen Elektroden-bzw. Emitteranschluß des ersten Transistors gekoppelt ist, und der weitere Elektroden- bzw. Kollektoranschluß des ersten Transistors dem Aktivteil und der weitere Elektroden- bzw. Kollektoranschluß des zweiten Transistors dem Abgleichteil zugeordnet ist.

Weitere Merkmale, Vorteile und Zweckmäßigkeiten der Erfindung ergeben sich aus der nachfolgenden Beschreibung bevorzugter Ausführungsbeispiele anhand der Zeichnung. Es zeigt:
Fig. 1 eine schematische Ansicht einer Laservorrichtung mit einer TTG-(Tunable Twin-Guide)-Laserdiode gemäß einem ersten Ausführungsbeispiel der Erfindung; und
Fig. 2 eine schematische Ansicht einer Laservorrichtung mit einem Zwei-Sektions-Laser gemäß einem zweiten Ausführungsbeispiel der Erfindung.

Bei den in der Zeichnung dargestellten Ausführungsbeispielen besitzt eine auf einem Halbleitersubstrat aus InP gefertigte wellenlängenabstimmbare Halbleiterlaserdiode 1 einen Aktivteil 2 mit einem aktiven Laserbereich 3 zur Erzeugung eines Laserlichtes mit einer vorbestimmten Emissionswellenlänge, und einen Abgleichteil 4 mit einem Abstimmbereich 5. Der aktive Laserbereich 3 mit einer typischen Schichtdicke von etwa 0,1 µm ist oberhalb einer in einer p-InGaAsP-Halbleiterschicht 10 ausgebildeten Gitterschicht 7 erster Ordnung mit einer typischen Gitterkonstante von etwa 240 nm ausgebildet, welches Gitter 7 auf einer p-dotierten InP-Bufferschicht 8 angeordnet ist. Der Abstimmbereich 5 mit einer typischen Schichtdicke von etwa 0,3 µm ist über eine typischerweise etwa 0,1 µm dünne n-dotierte InP-Zwischenschicht 9 elektronisch von dem aktiven Laserbereich 3 entkoppelt. Die beiden Halbleiterbereiche 3 und 5 sind somit (in an sich bekannter Weise) derart ausgebildet, daß der aktive Laserbereich 3 nach Anlegen eines zeitlich variablen Modulationsstromes, beispielsweise mit einer Frequenz von 10 GHz an eine Elektrode 11 Laserlicht mit einer vorbestimmten Emissionswellenlänge erzeugt wird, wobei die Wellenlänge innerhalb bestimmter Grenzen, beispielsweise bis etwa 7 nm durch einen an den Abstimmbereich 5 über die Elektrode 12 zugeführten Abgleichstrom von typischerweise etwa 20 mA veränderlich ist.

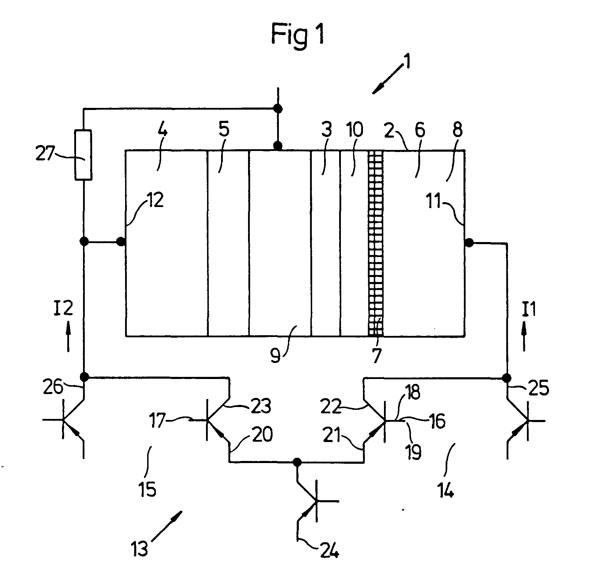

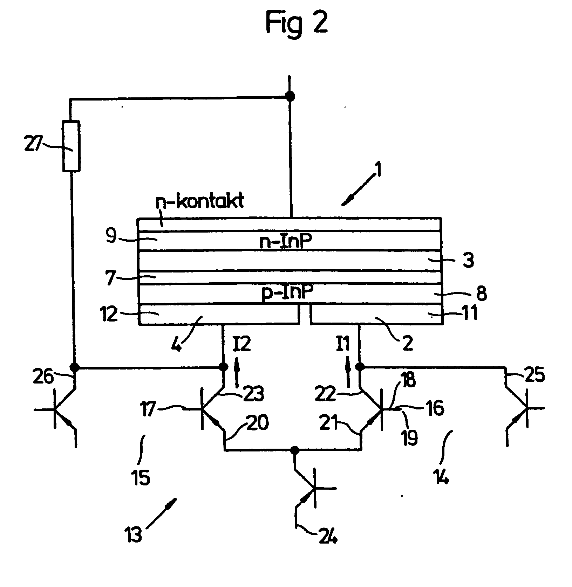

Erfindungsgemäß ist vorgesehen, daß der dem Abgleichteil zugeführte und die Emissionswellenlänge des ausgesandten Laserlichts steuernde Abgleichstrom I2 unmittelbar aus dem zeitlich variablen Modulationsstrom I1 derart abgeleitet ist, daß der auf den aktiven Laserbereich 3 wirkende Abstimmbereich 5 diesen so steuert, daß die Emissionswellenlänge des ausgesandten Laserlichts unabhängig von der Intensität des Modulationsstromes I1 und im wesentlichen wenigstens annähernd auf einem konstarten Wert gehalten wird. Der Abgleichstrom I2 wird hierbei unmittelbar derart aus dem Modulationsstrom I1 abgeleitet, daß in den beiden Halbleiterbereichen 3 und 5 die jeweiligen Ladungsträgerdichten bei der Modulation komplementär zueinander gesteuert werden, so daß sich die resultierenden optischen Eigenschaften des Resonatorvolumens nicht ändern. Auf diese Weise wird die im aktiven Laserbereich 3 in Abhängigkeit des angelegten zeitlich variablen Modulationsstromes I1 entstehende Frequenzmodulation kompensiert, so daß Chirpeffekte der Laservorrichtung 1 aufgehoben werden. Bei der schaltungstechnischen Realisierung nach Fig. 1 und 2 ist hierzu eine Differenzverstärkerschaltung 13 vorgesehen, die zwei untereinander gekoppelte Schaltungszweige 14 und 15 besitzt, wobei der eine Schaltungszweig 14 dem Aktivteil 2 zugeordnet ist und den zeitliche variablen Modulationsstrom für die direkte Modulation des aktiven Laserbereiches 3 führt, und der zweite Schaltungszweig 15 der Differenzverstärkerschaltung 13 dem Abgleichteil 4 zugeordnet ist und den unmittelbar aus dem Modulationsstrom I1 abgeleiteten Abgleichstrom I2 liefert. Bei den dargestellten Ausführungsbeispielen besitzt die Differenzverstärkerschaltung 13 einen dem ersten Schaltungszweig 14 zugeordneten ersten Transistor 16 und einen dem zweiten Schaltungszweig 15 zugeordneten zweiten Transistor 17. An dem Steueranschluß 18 des ersten Transistors 16 liegt ein dem zeitlich variablen Modulationsstrom I1 entsprechendes Steuersignal 19 an, wobei der Emitteranschluß 20 des zweiten Transistors 17 mit dem Emitteranschluß 21 des ersten Transistors 16 gekoppelt ist, und der Kollektoranschluß 22 des ersten Transistors 16 dem Aktivteil 2, und der Kollektoranschluß 23 des zweiten Transistors 17 dem Abgleichteil 4 zugeordnet ist. Der Differenzverstärkerschaltung 13 ist eine Stromquelle 24 zugeordnet. In der Praxis wird dem aktiven Laserbereich 3 ein vorbestimmter konstanter Modulationsvorstrom 25, und dem Abgleichteil 4 ein vorbestimmter konstanter Abgleichvorstrom 26 zugeführt. Der Modulationsvorstrom bzw. der Abgleichvorstrom kann unabhängig vom Modulationsstrom I1 bzw. Abgleichstrom I2 in gewünschter Weise auf einem jeweils konstanten Wert und unabhängig voneinander eingestellt sein. Erfindungswesentlich ist, daß der dem Abgleichteil 4 zugeführte Abgleichstrom I2 unmittelbar aus dem zeitlich variablen Modulationsstrom I1 abgeleitet wird. Insbesondere zur Anpassung unterschiedlicher Frequenzabhängigkeiten des aktiven Laserbereiches 3 und des Abstimmbereiches 5 kann ein Entzerrerglied 27 nachgeschaltet sein, welches im einfachsten Fall ein Dämpfungsglied darstellt, und darüber hinaus zur Pegelanpassung des Abgleichstromes, unter Umständen unter Vorzeichenumkehr des Stromes, dienen kann. Ganz allgemein kann das mit dem Bezugszeichen 27 angedeutete Entzerrerglied, welches lediglich zu Zwecken der Bezeichnung durch einen elektrischen Widerstand dargestellt ist, eine passive und aktive Beschaltung parallel zu dem Transistor 16 oder 17 oder zur TTG-Laserdiode 1 aufweisen, um statische oder dynamische Differenzen der Stromempfindlichkeit der beiden Laserbereiche 3 und 5 auszugleichen.

Bei dem in Fig. 2 dargestellten Ausführungsbeipiel ist an Stelle einer TTG-Laserdiode mit übereinanderliegendem aktiven und Abstimmbereich eine Zwei-Sektions-Laserdiode 1 vorgesehen, bei der der aktive Laserbereich 3 und der kompensierende Abstimmbereich 5 bezüglich der Lichtausbreitung in Reihe (longitudinale Sektionierung) liegen. Der Resonator der Laserdiode 1 selbst kann wie bei dem Ausführungsbeispiel nach Fig. 1 durch eine DFB-, DBR- oder eine Fabry-Perot-Anordnung ausgebildet sein.

## Patentansprüche

1. Wellenlängenabstimmbare Laservorrichtung (1) mit einem einen aktiven Laserbereich (3) aufweisenden Aktivteil (2) zur Erzeugung eines Laserlichtes mit einer vorbestimmten Emissionswellenlänge und einem einen dem aktiven Laserbereich (3) zugeordneten Abstimmbereich (5) aufweisenden und die Emissionswellenlänge des vom aktiven Bereich (3) ausgesandten Laserlichtes abstimmbaren Abgleichteil (4), wobei der Aktivteil (2) mit einem zeitlich variablen Modulationsstrom (I1) beaufschlagt ist, der die Intensität des ausgesandten Laserlichtes steuert, und der Abgleichteil (4) mit einem elektrischen Abgleichstrom (I2) zur Steuerung der Emissionswellenlänge des ausgesandten Laserlichtes beaufschlagt ist,
**dadurch gekennzeichnet, daß**
der dem Abgleichteil (4) zugeführte und die Emissionswellenlänge des ausgesandten Laserlichts steuernde Abgleichstrom (I2) unmittelbar aus dem zeitlich variablen Modulationsstrom (I1) abgeleitet ist, und der aus dem zeitlich variablen Modulationsstrom (I1) unmittelbar abgeleitete Abgleichstrom (I2) den auf den aktiven Laserbereich (3) wirkenden Abstimmbereich (5) so steuert, daß die Emissionswellenlänge des ausgesandten Laserlichts unabhängig von der Intensität des Modulationsstromes (I1) und im wesentlichen wenigstens annähernd auf einem konstanten Wert gehalten wird, wobei eine Differenzverstärkerschaltung (13) mit zwei untereinander gekoppelten Schaltungszweigen (14, 15) vorgesehen ist, wobei der eine Schaltungszweig (14) der Differenzverstärkerschaltung (13) dem Aktivteil (2) zugeordnet ist und den zeitlich variablen Modulationsstrom (I1) für die direkte Modulation des aktiven Laserbereiches (3) führt, und der zweite Schaltungszweig (15) der Differenzverstärkerschaltung (13) dem Abgleichteil (4) zugeordnet ist und den unmittelbar aus dem Modulationsstrom (I1) abgeleiteten Abgleichsstrom (I2) liefert.

2. Laservorrichtung nach Anspruch 1, **dadurch gekennzeichnet, daß** die Differenzverstärkerschaltung (13) einen dem ersten Schaltungszweig (14) zugeordneten ersten Transsitor (16) und einem dem zweiten Schaltungszweig (15) zugeordneten zweiten Transistor (17) aufweist, wobei an dem Steueranschluß (18) des ersten Transistors (16) ein dem zeitlich variablen Modulationsstrom entsprechendes Steuersignal (19) anliegt, und der eine Elektrodenanschluß (22) des zweiten Transistors mit dem einen Elektrodenanschluß (20) des ersten Transistors gekoppelt ist, und der weitere Elektrodenanschluß (21) des ersten Transistors dem Aktivteil (2) und der weitere Elektrodenanschluß (23) des zweiten Transistors (17) dem Abgleichteil (4) zugeordnet ist.

3. Laservorrichtung nach Anspruch 1 oder 2, **dadurch gekennzeichnet, daß** der Aktivteil (2) mit einem vorbestimmten konstanten Modulationsvorstrom (25) und der Abgleichteil (4) mit einem vorbestimmten konstanten Abgleichvorstrom (26) beaufsichtigt ist.

4. Laservorrichtung nach Anspruch 3, **dadurch gekennzeichnet, daß** der konstante Modulationsvorstrom (25) separat dem Aktivteil (2), und der konstante Abgleichvorstrom (26) separat dem Abstimmteil (5) zugeführt sind.

5. Laservorrichtung nach Anspruch 1 bis 4, **dadurch gekennzeichnet, daß** der Differenzverstärkerschaltung (13) eine Stromquelle (24) vorgeschaltet ist.

6. Laservorrichtung nach Anspruch 1 bis 5, **dadurch gekennzeichnet, daß** dem Abgieichteil (4) ein Entzerrerglied (27) vorgeschaltet ist.

7. Laservorrichtung nach Anspruch 1 bis 6, **dadurch gekennzeichnet, daß** der aktive Laserbereich (3) des Aktivteiles (2) und der Abstimmbereich (5) des Abgleichteiles (4) bezüglich der Ausbreitungsrichtung des ausgesandten Laserlichts in Reihe oder übereinander angeordnet sind.

8. Laservorrichtung nach Anspruch 1 bis 7, **dadurch gekennzeichnet, daß** sie eine Halbleiterlaserdiode mit DFB- oder DBR- oder Fabry-Perot-Anordnung darstellt.

## Claims

1. Wavelength tunable laser device (1) with an active part (2), having an active laser region (3), for generating laser light with a predetermined emission wavelength, and with a calibration part (4), which has a tuning region (5) assigned to the active laser region (3) and can tune the emission wavelength of the laser light emitted by the active region (3), there being applied to the active part (2) a temporally variable modulation current (I1) which controls the intensity of the emitted laser light, and an electric calibration current (I2) being applied to the calibration part (4) in order to control the emission wavelength of the emitted laser light, **characterized in that** the calibration current (I2) fed to the calibration part (4) and controlling the emission wavelength of the emitted laser light is derived directly from the temporally variable modulation current (I1), and the calibration current (I2) derived directly from the temporally variable modulation current (I1) controls the tuning region (5) acting on the active laser region (3) such that the emission wavelength of the emitted laser light is kept independent of the intensity of the modulation current (I1) and substantially at least approximately at a constant value, a difference amplifier circuit (13) with two intercoupled circuit branches (14, 15) being provided, one circuit branch (14) of the difference amplifier circuit (13) being assigned to the active part (2) and conducting the temporally variable modulation current (I1) for direct modulation of the active laser region (3), and the second circuit branch (15) of the difference amplifier circuit (13) being assigned to the calibration part (4) and supplying the calibration current (I2) derived directly from the modulation current (I1).

2. Laser device according to Claim 1, **characterized in that** the difference amplifier circuit (13) has a first transistor (16) assigned to the first circuit branch (14) and a second transistor (17) assigned to the second circuit branch (15), a control signal (19) corresponding to the temporally variable modulation current being present at the control terminal (18) of the first transistor (16) and one electrode terminal (22) of the second transistor being coupled to one electrode terminal (20) of the first transistor, and the further electrode terminal (21) of the first transistor being assigned to the active part (2) and the further electrode terminal (23) of the second transistor (17) being assigned to the calibration part (4).

3. Laser device according to Claim 1 or 2, **characterized in that** a predetermined constant biasing modulation current (25) is applied to the active part (2), and a predetermined constant biasing calibration current (26) is applied to the calibration part (4).

4. Laser device according to Claim 3, **characterized in that** the constant biasing modulation current (25) is fed separately to the active part (2), and the constant biasing calibration current (26) is fed separately to the tuning part (5).

5. Laser device according to Claims 1 to 4, **characterized in that** a current source (24) is connected upstream of the difference amplifier circuit (13).

6. Laser device according to Claims 1 to 5, **characterized in that** an equalizer element (27) is connected upstream of the calibration part (4).

7. Laser device according to Claims 1 to 6, **characterized in that** the active laser region (3) of the active part (2), and the tuning region (5) of the calibration part (4) are arranged in a row with reference to the direction of propagation of the emitted laser light, or one above another.

8. Laser device according to Claims 1 to 7, **characterized in that** it constitutes a semiconductor laser diode with a DFB or DBR or Fabry-Perot arrangement.

## Revendications

1. Dispositif (1) laser à longueur d'onde accordable, comprenant une partie (2) active comportant un domaine (3) laser actif et destinée à la production d'une lumière laser d'une longueur d'onde d'émission déterminée à l'avance et une partie (4) d'égalisation comportant un domaine (5) d'accord associé au domaine (3) laser actif et accordable à ia longueur d'onde d'émission de la lumière laser émise par le domaine (3) actif, la partie (2) active étant alimentée en un courant (I1) de modulation variable dans le temps, qui commande l'intensité de la lumière laser émise et la partie (4) d'égalisation étant alimentée en un courant (I2) électrique d'égalisation, destiné à commander la longueur d'onde d'émission de la lumière laser émise,
**caractérisé en ce que**
le courant (I2) d'égalisation envoyé à la partie (4) d'égalisation et commandant la longueur d'onde d'émission de la lumière laser émise est dérivé directement du courant (I1) de modulation variable dans le temps et le courant (I2) d'égalisation dérivé directement du courant (I1) de modulation variable dans le temps commande le domaine (5) d'accord agissant sur le domaine (3) laser actif de façon à maintenir à uns valeur au moins sensiblement approximativement constante la longueur d'émission de la lumière laser émise indépendamment de l'intensité du courant (I1) de modulation et il est prévu un circuit (13) amplificateur différentiel ayant deux branches (14, 15) de circuit couplées entre elles, l'une des branches (14) du circuit (13) amplificateur différentiel étant associée à la partie (2) active et il y passe le courant (I1) de modulation variable dans le temps pour la modulation directe du domaine (3) laser actif et la seconde branche (15) du circuit (13) amplificateur différentiel étant associée à la partie (4) d'égalisation et fournissant le courant (12) d'égalisation dérivé directement du courant (11) de modulation.

2. Dispositif laser suivant la revendication 1, **caractérisé en ce que** le circuit (13) amplificateur différentiel comporte un premier transistor (16) associé à la première branche (14) du circuit et un second transistor (17) associé à la seconde branche (15) du circuit, un signal (19) de commande correspondant au courant de modulation variable dans le temps étant appliqué à la borne (18) de commande du premier transistor (16) et l'une des bornes (22) d'électrode du second transistor étant couplée à une borne (20) d'électrode du premier transistor et l'autre borne (21) d'électrode du premier transistor étant associée à la partie (2) active et l'autre borne (23) d'électrode du second transistor (17) à la partie (4) d'égalisation.

3. Dispositif laser suivant la revendication 1 ou 2, **caractérisé en ce que** la partie (2) active est alimentée en un courant (25) de prédécharge de modulation constant, déterminé à l'avance et la partie (4) d'égalisation est alimentée en un courant (26) de prédécharge d'égalisation constant, déterminé à l'avance.

4. Dispositif laser suivant la revendication 3, **caractérisé en ce que** le courant (25) de prédécharge de modulation constant et le courant (26) de prédécharge d'égalisation constant sont envoyés séparément à la partie (2) active et au domaine (5) d'accord.

5. Dispositif laser suivant la revendication 1 à 4, **caractérisé en ce qu'**une source (24) de courant est montée en avant du circuit (13) amplificateur différentiel.

6. Dispositif laser suivant la revendication 1 à 5, **caractérisé en ce qu'**en amont de la partie (4) d'égalisation est prévu un élément (27) correcteur.

7. Dispositif laser suivant la revendication 1 à 6, **caractérisé en ce que** le domaine (3) laser actif de la partie (2) active et le domaine (5) d'accord de la partie (4) d'égalisation sont disposés en série ou superposés pour ce qui concerne la direction de propagation de la lumière laser émise.

8. Dispositif laser suivant la revendication 1 à 7, **caractérisé en ce qu'**il représente une diode laser à semi-conducteur à dispositif DFB ou DBR ou Fabry-Perot.
